# EUROPÄISCHE PATENTSCHRIFT

(11) **EP 0 815 601 B1**
(45) Veröffentlichungstag und Bekanntmachung des Hinweises auf die Patenterteilung: **13.01.1999**
(21) Anmeldenummer: 96904736.4
(22) Anmeldetag: 05.03.1996
(51) Int. Cl.: H01L 41/12

(54) **MAGNETOSTRIKTIVER AKTOR**
MAGNETOSTRICTIVE ACTUATORS
ACTIONNEUR MAGNETOSTRICTIF

(30) Priorität: 21.03.1995 DE 19510249
(43) Veröffentlichungstag der Anmeldung: 07.01.1998
(73) Patentinhaber: SIEMENS AKTIENGESELLSCHAFT, 80333 München (DE)
(72) Erfinder: MEIXNER, Hans, D-85540 Haar (DE); KAPPEL, Andreas, D-81369 München (DE); MOCK, Randolf, D-81739 München (DE)
(86) Internationale Anmeldenummer: DE9600384
(87) Internationale Veröffentlichungsnummer: WO9629748

(56) Entgegenhaltungen:
- EP-A- 0 251 468

## Beschreibung

### 1. Einleitung und Stand der Technik

Die spontane Längen- und Formänderung magnetischer Substanzen in einem die Magnetisierungsrichtung ändernden äußeren Magnetfeld wird als Magnetostriktion bezeichnet. Diesen Effekt nutzt man insbesondere in sogenannten Aktoren, um elektrische bzw. magnetische Energie in mechanische Energie umzuwandeln (s. beispielsweise /1/). Der magnetostriktive Effekt hängt oft in komplizierter Weise von der Magnetisierungsrichtung, jedoch nicht von deren Vorzeichen ab. Im Magnetfeld dehnen sich magnetostriktive Materialien nur vergleichsweise wenig. So beobachtet man bei Legierungen mit den Bestandteilen Eisen, Nickel oder Kobalt relative Längenänderungen im Bereich von Δl/l ≈ 10⁻⁵ bis 10⁻⁶. Wesentlich stärker ausge-prägt ist der magnetostriktive Effekt bei Seltenerdmetall-Eisenlegierungen, wo man Werte bis zu Δl/l ≈ 3.10⁻³ mißt.

Besondere Bedeutung für die Herstellung von magnetostriktiven Aktoren hat der Anfang der 60iger Jahre in den Vereinigten Staaten entwickelte und unter der Handelsbezeichnung TERFENOL bekannte Werkstoff TbₓDy₁₋ₓFe₂ (TERFENOL-D:x = 0,3) erlangt. Auf der Basis dieses durch die unten angegebenen Parameter

| | | | | |
|---|---|---|---|---|
| relative Längenänderung | Δl/l | 2-3 | (≤1,5 ) | 10⁻³ |
| Energiedichte | Eᵥ | 14...25 | ( 1 ) | 10³Ws/m³ |
| Druckfestigkeit | Tₜ | 700 | (>600 ) | N/mm² |
| Zugfestigkeit | Tₚ | 28 | (≈ 80 ) | N/mm² |
| Wärmeleitfähigkeit | λ | 110 | ( 1,2 ) | W/mK |
| Spez. el. Widerstand | ρₑₗ | 0,6 | | 10⁻⁶ Ωm |
| Curie-Temperatur | ϑ_{C} | 380 | ( 165 ) | °C |
| Dichte | ρ | 9,25 | ( 7,8 ) | kg/m³ |

gekennzeichneten Materials (die entsprechenden Werte der Piezokeramik PXE 52 stehen in Klammern ) lassen sich miniaturisierte Antriebselemente entwickeln, die bei vergleichbaren mechanischen Eigenschaften und Stellwegen ein gegenüber piezokeramischen Aktoren deutliches kleineres Bauvolumen aufweisen .

Der einer papierbespannten Walze gegenüberliegende Kopf des aus /2/ bekannten Tintenstrahldruckers weist eine Vielzahl linear angeordneter Düsen auf, welche jeweils mit einer Kammer und einem Vorratsbehälter für das Druckmedium in Verbindung stehen. Düsenplatte, Vorratsbehälter und zwei durch Abstandshalter voneinander getrennte Membranen bilden die Kammerwände. Die Membranen sind geschichtet aufgebaut, wobei die äußeren Schichten jeweils aus Nickel, die kammerseitigen Schichten beispielsweise aus einer Fe-Co-Ni-Legierung bestehen. Da diese Materialien sich in einem äußeren Magnetfeld verschieden stark dehnen, kann man das Volumen der Kammern durch Bestromen entsprechend plazierter Leiterelemente individuell ändern. Als Leiterelemente dienen Metallisierungen aus Kupfer, die in einen elektrischen Isolator eingehüllt und auf den äußeren bzw. kammerseitigen Membranflächen angeordnet sind.

Eine auf einem Biegeelement angeordnete magnetostriktive Dünnschicht bildet die aktive Komponente des aus /3/ bekannten elektromechanischen Wandlers. Das die Magnetostriktion hervorrufende äußere Magnetfeld erzeugt eine konventionelle Luftspule oder ein mit den Mitteln der Dickfilmtechnik hergestelltes Leiterbahnsystem. Um das Magnetfeld im Bereich des magnetostriktiven Materials zu verstärken, ist die Dünnschicht mit einem weichmagnetischen Material (Fe-Ni-Legierung) ummantelt.

Druckschrift /4/ beschreibt einen laminar aufgebauten magnetostriktiven Aktor, dessen jeweils nur etwa 80 µm dicke Schichten aus einer amorphen eisenhaltigen Legierung bestehen.

EP-A-0 251 468 beschreibt einen magnetostriktiven Aktor, in welchem magnetostriktive Platten und magnetische Platten abwechselnd angeordnet sind.

Hinsichtlich der Kompaktheit und der Ansprechzeiten sind die vergleichsweise große Stellkräfte erzeugenden, mit konventionellen Spulen ausgestatteten magnetostriktiven Antriebselemente entsprechend ausgelegten Piezoaktoren deutlich unterlegen. So beträgt die Ansprechzeit von piezokeramischen Wandlern typischerweise 50 µs bis 100 µs, die von magnetostriktiven Wandlern hingegen mindestens 1 µs - 10 ms. Dies liegt daran, daß das Magnetfeld im Bereich des Aktors eine Mindeststärke aufweisen muß, was die kleinstmögliche Induktivität der felderzeugenden Zylinderspule und damit auch die nicht unterschreitbare Mindestansprechzeit festlegt. Außerdem nehmen die das magnetostriktive Element umschließende Spule und die der magnetischen Flußführung dienenden Teile sehr viel Raum ein. Dies setzt der angestrebten Verkleinerung der Aktoren enge Grenzen und erschwert deren Verwendung als Antrieb von Pumpen, Einspritzventilen, Schallwandlern usw.

### 2. Ziele und Vorteile der Erfindung

Ziel der Erfindung ist die Schaffung eines magnetostriktiven Aktors, der kompakt aufgebaut ist und große Stellkräfte erzeugen kann. Aktoren mit den in den Patentansprüchen 1, 4 und 5 angegebenen Merkmalen besitzen diese Eigenschaft. Die abhängigen Ansprüche betreffen Ausgestaltung und Weiterbildungen der Aktoren.

Die Integration der felderzeugenden Spule in das Antriebselement ermöglicht den Bau kompakter Aktoren, die große Stellkräfte von beispielsweise 2000 N-5000 N erzeugen können. In bekannten magnetostriktiven Aktoren sind die stellweg- und magnetfelderzeugenden Komponenten funktionell voneinander getrennt. Die Erfindung hebt diese Trennung weitgehend auf, da man die mit elektrischen Anschlüssen versehenen magnetostriktiven Schichten selbst als Spulenelemente verwendet.

### 3. Zeichnungen

Die Erfindung wird im folgenden anhand der Zeichnungen erläutert. Hierbei zeigt:
- Fiaur 1: ein Antriebselement des Aktors,
- Figur 2: zwei winkelversetzt übereinander angeordnete Antriebselemente,
- Figur 3 bis 5: weitere Ausführungsbeispiele erfindungsgemäßer Aktoren,
- Figur 6: Verfahrensschritte zur Herstellung eines magnetostriktiven Vielschichtaktors.

### 4. Ausführungsbeispiele magnetostriktiver Aktoren

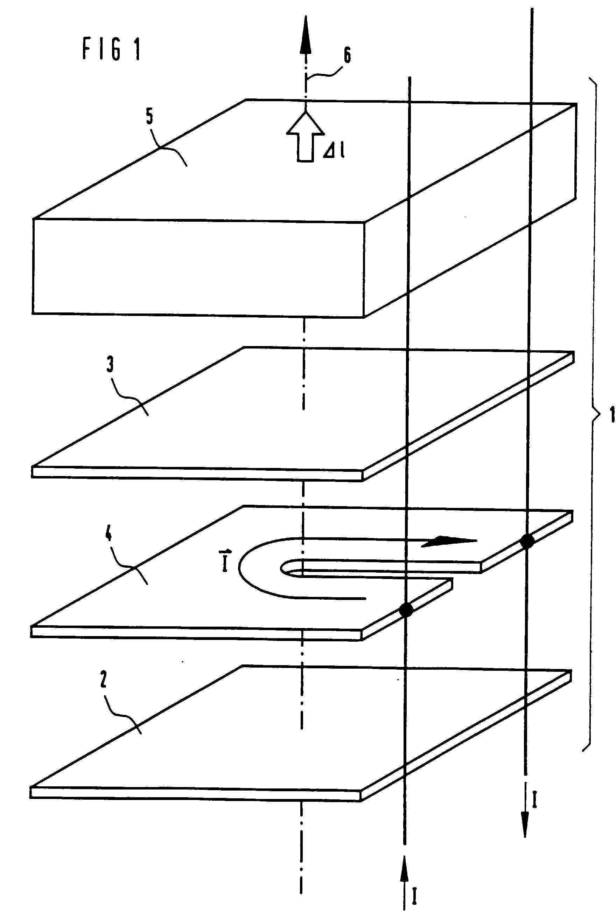

Ein erfindungsgemäßer Aktor enthält typischerweise etwa N ≈ 100 stapelförmig übereinander angeordnete, jeweils geschichtet aufgebaute und mit elektrischen Anschlüssen versehene Antriebselemente. Wie die Figur 1 schematisch zeigt, kann ein Antriebselement 1 aus einem zwischen zwei elektrischen Isolatoren 2, 3 angeordneten Silber-, Platin- oder Palladiumplättchen 4 und einem aus einem magnetostriktiven Material, insbesondere Tb_{0,3}Dy_{0,7}Fe₂ (TERFENOL-D) gefertigten Aktorelement 5 bestehen. Stromdurchflossen wirkt das von der Mitte einer Seitenkante bis hin zum Zentrum geschlitzte Metallplättchen 4 als ebene Ringspule, deren Magnetfeld das quader- oder scheibenförmige Aktorelement 5 durchsetzt und dort Magnetostriktion hervorruft. Als Isolatoren 2, 3 kommen insbesondere SiO₂-, Si₃N_{4-,} Al₂O₃-oder Polyimidschichten in Betracht. Selbstverständlich kann man die elektrische Isolation der Ringspule 4 auch durch Auflamminieren einer Folie, durch Beschichten mit einem Epoxidharz oder durch Oxidation der magnetostriktiven Schicht 5 bewerkstelligen.

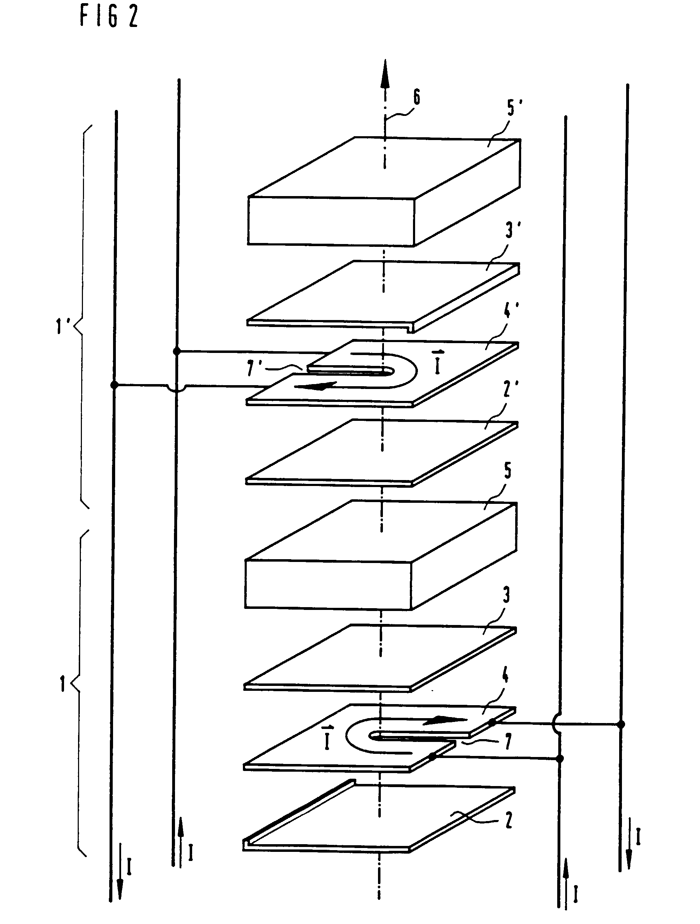

Aufgrund ihrer Bauform läßt sich mit der ebenen Ringspule 4 kein bezüglich der Stapelachse 6 rotationssymmetrisches Magnetfeld erzeugen. Das einem solchen Feld ausgesetzte magnetostriktive Element 5 erfährt somit unsymmetrische Dehnungen, was im Material unter Umständen sehr große mechanische Spannungen verursacht. Um den vorzeitigen Ausfall des Aktors durch Bruch eines seiner Antriebselements 1,1' zu verhindern, werden diese winkelversetzt übereinander angeordnet(siehe Fig. 2). Im Bereich der magnetostriktiven Schicht 5 baut sich insbesondere dann ein vergleichsweise homogenes Magnetfeld auf, wenn die Schlitze 7, 7' der Ringspulen 4, 4' einen Azimutwinkel ϕ = 180° einschließen.

Die Integration der Magnetspule in das Antriebselement 1, 1' ermöglicht den Bau kompakter Aktoren. Außerdem sprechen die Aktoren sehr schnell auf Ansteuersignale an, da die ebenen Ringspulen 4, 4' jeweils nur sehr kleine Induktivitäten besitzen. Ein weiterer Vorteil gegenüber konventionellen Aktoren mit ihren im Innern zylindrischer Spulen angeordneten Stellgliedern besteht darin, daß keine flußführenden Elemente (Polschuhe usw.) erforderlich sind und kaum Feldverluste durch Luftspalte auftreten.

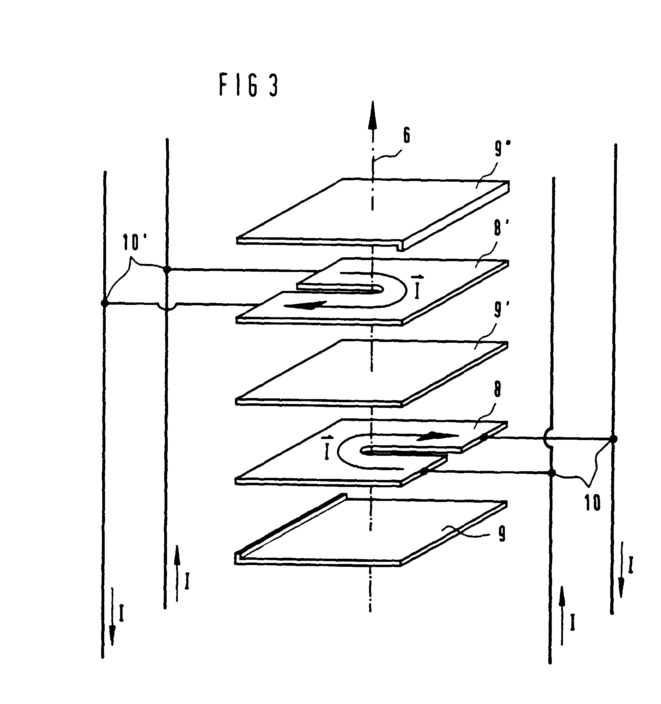

Der Aufbau des erfindungsgemäßen Aktors läßt sich weiter vereinfachen, indem man die hohe elektrische Leitfähigkeit magnetostriktiver Materialien nutzt und das Aktorelement selbst als ebene Ringspule ausbildet. In diesem Fall trägt dann sowohl das von dem im magnetostriktiven Material fließenden Strom erzeugte innere Magnetfeld (H ~ r) als auch das äußere Magnetfeld (H ~ 1/r) benachbarter Ringspulen zum gewünschten Effekt bei. Wie die Figur 3 zeigt, enthält ein solcher Aktor typischerweise N ≈ 100 geschlitzte Terfenolplättchen 8, 8', die jeweils zwischen Isolatoren 9, 9', 9" winkelversetzt angeordnet (Azimutwinkel ϕ = 180°) und mit elektrischen Anschlüssen 10, 10' versehen sind.

Um die ohmschen Verluste zu verringern, die Korrosionsbeständigkeit des Aktors zu erhöhen und die Homogenität der magnetischen Induktion in den magnetostriktiven Schichten zu verbessern, kann man die Ringspulen 9, 9' noch mit einem elektrisch gut leitenden Material wie Au, Ag, Al, Cu, Ni, W, Ti, Pt oder Pa beschichten. Es ist selbstverständlich auch möglich, im Aktor metallische, mit einem elektrostriktiven Material beschichtete Ringspulen zu verwenden. Eine erhebliche Verstärkung der magnetischen Induktion läßt sich erzielen, indem man die Leiterschicht aus einem hochpermeablen Material fertigt bzw. eine aus einem ferromagnetischen Material (Ko, Ni, Fe) bestehende weitere Schicht auf oder in der Nähe der felderzeugenden/magnetostriktiven Elemente 8, 8' anordnet. Bei der Herstellung der magnetostriktiven Schichten, der elektrischen Leiter und der hochpermeablen ferromagnetischen Schichten kommen insbesondere physikalische und chemische Abscheideverfahren zur Anwendung. Zu nennen sind hier beispielsweise RF- bzw. DC-Sputtern, Aufdampfen, CVD-Verfahren oder die galvanische Schichtabscheidung.

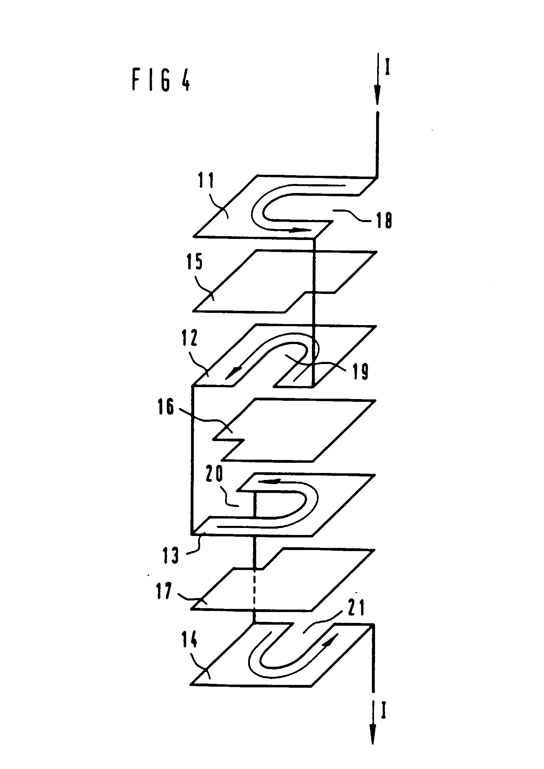

Die Figur 4 zeigt ein weiteres Ausführungsbeispiel eines Aktors. Hier sind die u-förmig geschlitzten Terfenolbleche 11 - 14 und die Isolatorschichten 15 - 17 abwechselnd derart übereinander angeordnet, daß der in die obere Ringspule 11 eingespeiste und an der unteren Ringspule 14 abgeleitete Strom den Aktor schraubenförmig durchfließt. Um dies zu bewerkstelligen, schließen die Schlitze 18 - 21 benachbarter Ringspulen 11 - 14 einen Azimutwinkel von jeweils ϕ = 90° ein, wobei die Drehrichtung innerhalb des Stapels erhalten bleibt. Das im Aktor aufgebaute Magnetfeld entspricht dann dem einer konventionellen Zylinderspule. Es läßt sich erheblich verstärken, indem man die ebenen Ringspulen 11 bis 14 mit einem ferromagnetischen Material beschichtet bzw. ferromagnetische Schichten in der Nähe der Ringspulen 11 bis 14 anordnet.

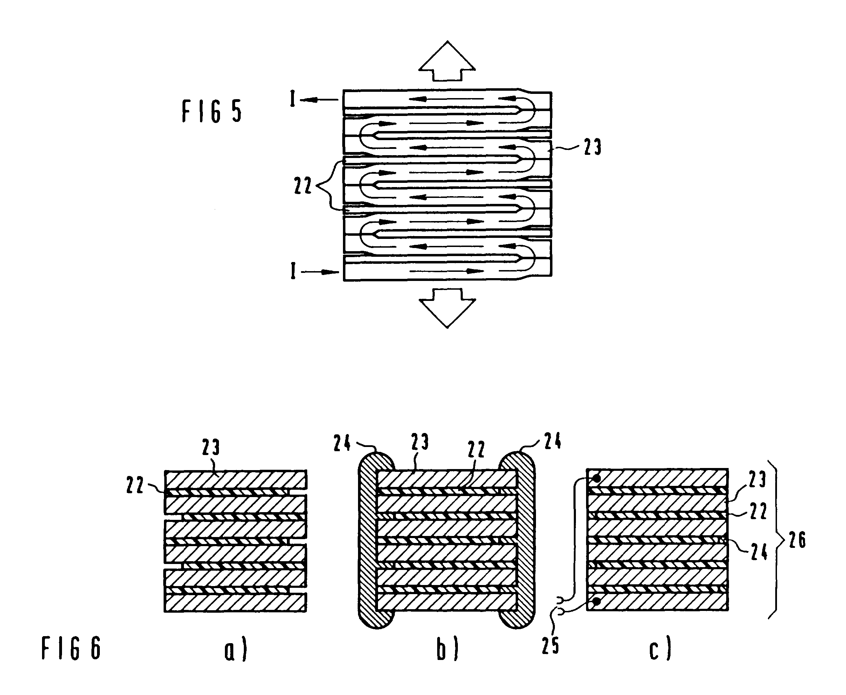

Der in Figur 5 dargestellte Aktor besitzt einen geschichteten Aufbau mit alternierend angeordneten Lamellen aus magnetostriktiven und elektrisch isolierenden Material. Die spezielle Ausrichtung der flächenmäßig kleineren isolierenden Zwischenschichten 22 gegenüber den magnetostriktiven Lamellen 23 ermöglicht auch ohne aufwendige äußere Kontaktierung eine durchgängige elektrisch leitende Verbindung der einzelnen Aktorelemente nach Art einer Reihenschaltung. Der dadurch verwirklichte mäanderförmige Strompfad führt zu einer homogenen Stromdichteverteilung in den leitenden Schichten 23. Außerdem wird das magnetische Streufeld sehr stark reduziert.

Die Figur 6 dient der Erläuterung eines Verfahrens zur Herstellung eines geschichtet aufgebauten Aktors. Mit Hilfe eines physikalischen oder chemischen Abscheideprozesses erzeugt man zunächst die gewünschte Anzahl und Folge von Schichten - magnetostriktives Material - Isolator -magnetostriktives Material - Isolator - usw. und verbindet diese durch einfaches Verpressen oder Sintern (Figur 6a). Die Kontaktierung der magnetostriktiven Schichten 23 erfolgt durch Auffüllen der Zwischenräume mit einem elektrisch leitenden Material 24 (beispielsweise Al, Au, Ag, Cu, Ni). Hierbei kommen die aus der Herstellung von Vielschicht-Piezokeramiken oder mehrlagigen Leiterplatten bekannten Verfahren zur Anwendung. Zu nennen sind hier das Flammspritzen, die elektrogalvanische oder die chemogalvanische Abscheidung (Figur 6b). Die Figur 6c zeigt den durch Trennsägen erzeugten und mit elektrischen Anschlüssen 25 versehenen Quader-, Zylinder- oder ringförmigen Aktorkörper 26. Dieser wird noch mit einer Passivierung ummantelt und anschließend gesintert (nicht dargestellt).

Die Erfindung beschränkt sich selbstverständlich nicht auf die beschriebenen Ausführungsbeispiele. So kann man insbesondere die in den Figuren 1 und 2 mit 4 bzw. 4' bezeichneten Metallplättchen jeweils durch ein u-förmiges Leiterelement mit vergleichsweise schmalen Schenkeln ersetzen. Das im Aktor aufgebaute Magnetfeld ist dann deutlich homogener und annähernd parallel zur Stapelachse 6 orientiert.

### 5. Literatur

/1/ H. Janocha; Aktoren, Grundlagen und Anwendungen; Springer Verlag (1992), S. 278 - 293
/2/ US 4 032 929
/3/ DE 42 20 226 A1
/4/ US 4 757 219

## Patentansprüche

1. Magnetostriktiver Aktor mit einer Anzahl N ≥ 2 Antriebselementen (1, 1'), wobei die Antriebselemente (1, 1')
- geschichtet aufgebaut sind und jeweils
- ein mit elektrischen Anschlüssen versehenes ebenes Leiterelement (4, 4'),
- ein aus einem magnetostriktiven Material bestehendes Aktorelement (5, 5') sowie
- einen zwischen dem Leiterelement (4, 4') und dem Aktorelement (5, 5') angeordneten elektrischen Isolator (3, 3') aufweisen,
**dadurch gekennzeichnet,**
daß die U-förmig ausgebildeten oder mit einem Schlitz versehenen Leiterelemente (4, 4') innerhalb eines Stapels der Antriebselemente (1, 1') derart winkelversetzt übereinander angeordnet sind, daß sich ein in Richtung Stapelachse (6) orientiertes Magnetfeld aufbaut.

2. Magnetostriktiver Aktor nach Patentanspruch 1,
**dadurch gekennzeichnet,**
daß benachbarte Leiterelemente (1, 1') um 180° winkelversetzt übereinander angeordnet sind.

3. Magnetostriktiver Aktor nach Anspruch 1 oder 2,
**dadurch gekennzeichnet,**
daß die Leiterelemente (4, 4') jeweils zwischen zwei Isolatoren (2, 2', 3, 3') angeordnet sind.

4. Magnetostriktiver Aktor mit den folgenden Merkmalen:
a) Er enthält eine Anzahl N ≥ 2 ebene, durch elektrische Isolatoren (9, 9') voneinander getrennte Leiterelemente (8, 8'), wobei die Leiterelemente (8, 8')
b) aus einem magnetostriktiven Material gefertigt,
c) jeweils mit elektrischen Anschlüssen versehen und
d) derart stapelförmig übereinander angeordnet sind, daß sie im bestromten Zustand ein in Richtung Stapelachse (6) orientiertes Magnetfeld erzeugen.

5. Magnetostriktiver Aktor mit den folgenden Merkmalen:
a) Er enthält eine Anzahl N ≥ 2 ebene, durch elektrische Isolatoren (15, 16, 17) voneinander getrennte Leiterelemente (11 bis 14), wobei die Leiterelemente (11 bis 14)
b) aus einem magnetostriktiven Material gefertigt,
c) elektrisch in Reihe geschaltet und
d) derart stapelförmig übereinander angeordnet sind, daß der an einem Anschluß eines ersten Leiterelements (11) eingespeiste und über einen Anschluß des N-ten Leiterelementes (14) abfließende Strom (I) ein in Richtung Stapelachse orientiertes Magnetfeld erzeugt.

6. Magnetostriktiver Aktor nach Anspruch 4 oder 5,
**dadurch gekennzeichnet,**
daß die Leiterelemente (1, 1', 8, 8') als ebene Ringspulen ausgebildet sind.

7. Magnetostriktiver Aktor nach einem der Ansprüche 4 bis 6,
**gekennzeichnet durch**
geschlitzte platten-, scheiben- oder ringförmige Leiterelemente (1, 1', 8, 8').

8. Magnetostriktiver Aktor nach einem der Ansprüche 4 bis 7,
**dadurch gekennzeichnet,**
daß die Leiterelemente (1, 1', 8, 8') winkelversetzt übereinander angeordnet sind.

9. Magnetostriktiver Aktor nach Anspruch 8,
**dadurch gekennzeichnet,**
daß die Leiterelemente (1, 1', 8, 8') derart winkelversetzt angeordnet sind, daß sich ein schraubenförmiger Strompfad ergibt.

10. Magnetostriktiver Aktor nach einem der Ansprüche 1 bis 9,
**dadurch gekennzeichnet,**
daß die aus einem magnetostriktiven Material bestehenden Leiter- oder Aktorelemente (1, 1', 5, 5', 8, 8') mit einem elektrisch leitenden Material beschichtet oder die Leiter- bzw. Aktorelemente auf einer elektrisch leitenden Schicht aufgebracht sind.

11. Magnetostriktiver Aktor nach Anspruch 10,
**dadurch gekennzeichnet,**
daß das elektrisch leitfähige Material ferromagnetische Eigenschaften besitzt bzw. die elektrisch leitende Schicht aus einem ferromagnetischen Material besteht.

12. Magnetostriktiver Aktor nach einem der Ansprüche 1 bis 11,
**dadurch gekennzeichnet,**
daß die Isolatoren (2, 2', 3, 3') aus einem Dielektrikum, einer Isolierfolie oder einem Isolierlack bestehen, durch Oxidation der Oberfläche des magnetostriktiven Materials oder durch Oxidation der Oberfläche der Leiterelemente hergestellt sind.

## Claims

1. Magnetostrictive actuator having a number N ≥ 2 of drive elements (1, 1'), the drive elements (1, 1')
- being of layered construction and in each case having
- a planar conductor element (4, 4') which is provided with electrical connections,
- an actuator element (5, 5') which is composed of a magnetostrictive material, and
- an electrical insulator (3, 3') which is arranged between the conductor element (4, 4') and the actuator element (5, 5'),
characterized
in that the conductor elements (4, 4'), which are designed in a U-shape or are provided with a slot, are arranged at offset angles one above the other within a stack of the drive elements (1, 1') in such a manner that a magnetic field is built up which is oriented in the direction of the stack axis (6).

2. Magnetostrictive actuator according to Patent Claim 1,
characterized
in that adjacent conductor elements (4, 4') are arranged offset at an angle of 180° one above the other.

3. Magnetostrictive actuator according to Claim 1 or 2,
characterized
in that the conductor elements (4, 4') are each arranged between two insulators (2, 2', 3, 3').

4. Magnetostrictive actuator having the following features:
a) Said actuator contains a number N ≥ 2 of planar conductor elements (8, 8') which are separated from one another by electrical insulators (9, 9'), the conductor elements (8, 8')
b) being manufactured from a magnetostrictive material,
c) each being provided with electrical connections and
d) being arranged one above the other in the form of a stack in such a manner that, when current is flowing, they produce a magnetic field which is oriented in the direction of the stack axis (6).

5. Magnetostrictive actuator having the following features:
a) Said actuator contains a number N ≥ 2 of planar conductor elements (11 to 14) which are separated from one another by electrical insulators (15, 16, 17), the conductor elements (11 to 14)
b) being manufactured from a magnetostrictive material,
c) being electrically connected in series and
d) being arranged one above the other in the form of a stack in such a manner that the current (I) which is supplied to a connection of a first conductor element (11) and flows away via a connection of the N-th conductor element (14) produces a magnetic field which is oriented in the direction of the stack axis.

6. Magnetostrictive actuator according to Claim 4 or 5,
characterized
in that the conductor elements (1, 1', 8, 8') are designed as planar annular coils.

7. Magnetostrictive actuator according to one of Claims 4 to 6,
characterized by
slotted conductor elements (1, 1', 8, 8') in the form of plates, discs or rings.

8. Magnetostrictive actuator according to one of Claims 4 to 7,
characterized
in that the conductor elements (1, 1', 8, 8') are arranged at offset angles one above the other.

9. Magnetostrictive actuator according to Claim 8,
characterized,
in that the conductor elements (1, 1', 8, 8') are arranged at offset angles one above the other in such a manner that a helical current path is produced.

10. Magnetostrictive actuator according to one of Claims 1 to 9,
characterized
in that the conductor or actuator elements (1, 1', 5, 5', 8, 8'), which are composed of a magnetostrictive material, are coated with an electrically conductive material, or the conductor and/or actuator elements are mounted on an electrically conductive layer.

11. Magnetostrictive actuator according to Claim 10,
characterized
in that the electrically conductive material has ferromagnetic characteristics and/or the electrically conductive layer is composed of a ferromagnetic material.

12. Magnetostrictive actuator according to one of Claims 1 to 11,
characterized
in that the insulators (2, 2', 3, 3') are composed of a dielectric, an insulating film or an insulating varnish and are produced by oxidation of the surface of the magnetostrictive material or by oxidation of the surface of the conductor elements.

## Revendications

1. Actionneur magnétostrictif comprenant un nombre N ≥ 2 d'éléments d'actionnement (1, 1'), les éléments d'actionnement (1, 1')
- ayant une structure en couches et étant pourvus, à chaque fois,
- d'un élément conducteur plan (4, 4') pourvu de connexions électriques,
- d'un élément actionneur (5, 5') formé d'un matériau magnétostrictif, ainsi que
- d'un isolant électrique (3, 3') situé entre l'élément conducteur (4, 4') et l'élément actionneur (5, 5'),
caractérisé en ce que les éléments conducteurs (4, 4') exécutés en forme de U ou pourvus d'une fente sont superposés à l'intérieur d'un empilement des éléments d'actionnement (1, 1') et avec un décalage angulaire, de manière à ce que soit produit un champ magnétique orienté dans la direction de l'axe (6) de l'empilement.

2. Actionneur magnétostrictif selon la revendication 1, caractérisé en ce que les éléments conducteurs contigus (1, 1') sont superposés avec un décalage angulaire de 180°.

3. Actionneur magnétostrictif selon l'une des revendications 1 ou 2, caractérisé en ce que les éléments conducteurs (4, 4') sont situés, à chaque fois, entre deux isolants (2, 2', 3, 3').

4. Actionneur magnétostrictif possédant les caractéristiques suivantes:
a) II contient un nombre N ≥ 2 d'éléments conducteurs plans (8, 8') séparés les uns des autres par des isolants électriques (9, 9'), les éléments conducteurs (8, 8')
b) étant fabriqués dans un matériau magnétostrictif,
c) étant pourvus à chaque fois de connexions électriques et
d) étant empilés les uns sur les autres de manière à générer, lorsqu'ils sont parcourus par un courant, un champ magnétique orienté dans la direction de l'axe (6) de l'empilement.

5. Actionneur magnétostrictif possédant les caractéristiques suivantes:
a) II contient un nombre N ≥ 2 d'éléments conducteurs plans (11 à 14) séparés les uns des autres par des isolants électriques (15, 16, 17), les éléments conducteurs (11 à 14)
b) étant fabriqués dans un matériau magnétostrictif,
c) faisant l'objet d'un montage électrique en série, et
d) étant empilés les uns sur les autres de manière à ce que le courant (I) alimenté au niveau d'une connexion d'un premier élément conducteur (11) et sortant par une connexion du N-ième élément conducteur (14) génère un champ magnétique orienté dans la direction de l'axe de l'empilement.

6. Actionneur magnétostrictif selon l'une des revendications 4 ou 5, caractérisé en ce que les éléments conducteurs (1, 1', 8, 8') sont exécutés en tant que bobines toroïdales planes.

7. Actionneur magnétostrictif selon l'une des revendications 4 à 6, caractérisé par des éléments conducteurs (1, 1', 8, 8') fendus, en forme de plaque, de disque, ou de forme annulaire.

8. Actionneur magnétostrictif selon l'une des revendications 4 à 7, caractérisé en ce que les éléments conducteurs (1, 1', 8, 8') sont superposés avec un décalage angulaire.

9. Actionneur magnétostrictif selon la revendication 8, caractérisé en ce que les éléments conducteurs (1, 1', 8, 8') présentent un décalage angulaire, de manière à ce que l'on obtienne un trajet du courant en forme de spirale.

10. Actionneur magnétostrictif selon l'une des revendications 1 à 9, caractérisé en ce que les éléments conducteurs ou actionneurs (1, 1', 5, 5', 8, 8') formés d'un matériau magnétostrictif sont pourvus d'une couche de matériau électroconducteur, ou les éléments conducteurs resp. actionneurs sont appliqués sur une couche électroconductrice.

11. Actionneur magnétostrictif selon la revendication 10, caractérisé en ce que le matériau électroconducteur possède des propriétés ferromagnétiques resp. la couche électroconductrice est formée d'un matériau ferromagnétique.

12. Actionneur magnétostrictif selon l'une des revendications 1 à 11, caractérisé en ce que les isolants (2, 2', 3, 3') sont formés par un diélectrique, une feuille isolante ou un vernis isolant, sont fabriqués par oxydation de la surface du matériau magnétostrictif ou par oxydation de la surface des éléments conducteurs.
